Europäisches Patentamt

European Patent Office

Office européen des brevets

(11) Veröffentlichungsnummer: **0 300 183 B1**

## EUROPÄISCHE PATENTSCHRIFT

(45) Veröffentlichungstag der Patentschrift: **15.04.92**

(51) Int. Cl.⁵: **G01B 21/22**

(21) Anmeldenummer: **88109187.0**

(22) Anmeldetag: **09.06.88**

(54) **Messeinrichtung und Verfahren zur Lageistwerterfassung.**

(30) Priorität: **24.06.87 DE 3720828**

(43) Veröffentlichungstag der Anmeldung:
**25.01.89 Patentblatt 89/04**

(45) Bekanntmachung des Hinweises auf die
Patenterteilung:
**15.04.92 Patentblatt 92/16**

(84) Benannte Vertragsstaaten:
**CH DE FR GB IT LI NL SE**

(56) Entgegenhaltungen:
**DE-A- 3 243 956**
**DE-A- 3 246 959**
**DE-A- 3 407 102**
**DE-A- 3 416 090**
**DE-A- 3 429 648**

(73) Patentinhaber: **ROBERT BOSCH GMBH**
**Postfach 30 02 20**
**W-7000 Stuttgart 30(DE)**

(72) Erfinder: **Meister, Werner, Ing.grad.**
**Pestalozzistrasse 4**
**W-6101 Reichelsheim(DE)**
Erfinder: **Saul, Gert, Ing.grad.**
**Rubensstrasse 6**
**W-6120 Erbach(DE)**

## Beschreibung

Die Erfindung betrifft eine Meßeinrichtung sowie ein Verfahren nach den Oberbegriffen der unabhängigen Patentansprüche 1 und 7, wie sie zur Steuerung eines Servoantriebes z. B. zur Lageregelung von Werkzeugmaschinen, Industrierobotern usw. verwendet werden.

An einfachen und kostengünstigen Maschinen werden für die Lageistwerterfassung überwiegend inkrementale Drehgeber verwendet, die mechanisch mit dem Antrieb verbunden sind (indirektes Meßsystem). Hierbei wird nach dem Einschalten eine aufwendige, zeitraubende Prozedur erforderlich, um den Ausgangswert des Lagegebers zu erfassen. Üblicherweise wird hierbei ein genau vermessener Referenzpunkt mit geringer Geschwindigkeit angefahren und der dort bekannte Lageistwert eingestellt. Dies läßt sich vermeiden, wenn anstelle des inkrementalen Drehgebers ein Absolutwertgeber verwendet wird, über dessen Signale sich in jeder Lage der Lageistwert ermitteln läßt.

Werden inkrementale Drehgeber verwendet, müssen üblicherweise zusätzliche Maßnahmen ergriffen werden, die verhindern, daß durch Störimpulse oder Ausfall von Einzelimpulsen eine Fehlmessung erfolgt, wobei vor allem das Aufaddieren von Fehlern verhindert werden muß. Hierbei ist es bekannt, über das Referenzsignal einer Nullwert-Referenzmarke, mit Hilfe einer Zählkontrolle der Inkrementalimpulse, Fehler zu erkennen.

Zur genauen Steuerung (im Mikrometerbereich) werden nochauflösende Präzisions-Meßeinrichtungen erforderlich, die sehr aufwendig und teuer sind. Während sich hochauflösende inkrementale Drehgeber verhältnismäßig kostengünstig herstellen lassen und nur wenige Signale abgeben, die über abgeschirmte Leitungen mit geringer übersprechempfindlichkeit zur Steuerung geführt werden müssen, ist die Herstellung von Absolutwertgebern aufwendig und es müssen, vor allem wenn der maximale Verfahrweg groß ist, sehr viele Signale über getrennte Leitungen zur Steuerung geführt werden. Weiterhin steigt durch die wesentlich größere Anzahl von Signalgebern auch die Ausfallrate.

Um dies zu vermeiden, ist es bekannt, (siehe DE-OS 34 16 090 und EP-OS 0 201 106) einen Inkrementalgeber zusätzlich über Zahnräder mit weiteren Geberscheiben zu verbinden, auf denen sich jeweils eine zusätzliche Referenzmarke befindet, die nach jeder Umdrehung eine andere Stellung einnimmt. In einem Mikroprozessor wird dann aus der Lage der zusätzlichen Referenzsignale der Drehwert des inkrementalen Drehgebers errechnet. Die Ermittlung der Umdrehungszahl erfolge dort in ähnlicher Weise wie bei der Meßeinrichtung gemäß der DE-PS 24 16 212.

Bei einer Meßeinrichtung gemäß der DE-OS 34 16 090 oder der EP-OS 0 201 106 wird insbesondere für hochauflösende inkrementale Drehgeber eine hohe Präzision erforderlich, da die Signale aus den zusätzlichen Referenzsignalgebern zu einem vorgegebenen Inkrement des inkrementalen Drehgebers abgegeben werden müssen. Bei dem dort angegebenen Beispiel mit 4000 Teilungsperioden auf der Inkrementalscheibe müssen nach der maximalen Drehzahl die zusätzlichen Referenzsignale um 5,4 Minuten (0,09 Winkelgrade) genau erzeugt werden. Dies bedeutet, daß sehr große Scheiben verwendet werden müssen oder eine Eichung im Mikrometerbereich erfolgen muß, die bei einer Anordnung am Antrieb mit den dort vorhandenen großen Temperaturänderungen kaum möglich ist. Weiterhin kann durch Störimpulse oder fehlende Impulse ein falscher Umdrehungswert initialisiert werden, der erhebliche Störungen verursachen kann.

Aufgabe der Erfindung ist es, diese Nachteile zu vermeiden und mit einem hochauflösendem inkrementalen Drehgeber eine Lageistwerterfassung zu ermöglichen, mit der nach kurzem Verfahrweg der genaue absolute Lageistwert ermittelt werden kann. Zur Erhöhung der Fehlersicherheit soll die Zahl der für die Bestimmung eines Lageistwertes zu übermittelnden Daten Kleingehalten werden.

Die Aufgabe wird durch die in den unabhängigen Patentansprüchen 1 und 7 gekennzeichneten Merkmale gelöst. Die Getriebe und Absolutwertgeber benötigen keine große Präzision, da nur die jeweilige Umdrehungszahl erfaßt werden muß. Eine Abfrage des Absolutwertgebers kann gezielt immer dann erfolgen, wenn das Referenzsignal Rz des Drehwertgebers anliegt, so daß Toleranzen bis nahezu einer Umdrehung des Drehwertgebers keine Rolle spielen.

Bei absoluten Weggebern, z. B. gemäß der DE-OS 30 06 367 und DE 34 07 102, ist es an sich bekannt, zur Vergrößerung der Auflösung bzw. des Bereiches der Absolutwertmessung vor dem Absolutwertgeber eine oder mehrere Codescheiben mit Inkrementalwerten vorzusehen, die über Untersetzungsgetriebe mit dem Absolutwertgeber verbunden sind. Mit der Vergrößerung der Auflösung erhöht sich jedoch auch hier der Stellenwert des Absolutwertsignales wie bei Absolutwertgebern mit weiteren Codespuren. In der DE-OS 34 07 102 wird ein Lösungsweg angegeben, wie mit Hilfe einer zusätzlichen Rasterscheibe auch mit ungenauen Untersetzungsgetrieben noch richtige Absolutwerte erfaßt werden können. Um nach dem Einschalten oder nach einem Ausfall der Betriebsspannung den genauen Absolutwert ermitteln zu können wird es erforderlich, den Zählerstand des hierbei erforderlichen Zählers über einen Langzeitspeicher (z. B.

EP 0 300 183 B1

mit Hilfe einer zusätzlichen Batteriespannung) abzuspeichern. Dies hat den Nachteil, daß nach Abschalten oder Ausfall der Betriebsspannung erfolgende Auslaufbewegungen oder andere Positionsbewegungen, z. B. von Hand, nicht mehr erfaßt werden und zu Fehlern führen können.

Eine besonders vorteilhafte Ausgestaltung der Erfindung er gibt sich, wenn direkt am Inkremental- und Absolutwertgeber eine Zähllogik vorgesehen ist, die abhängig vom Umdrehungswert versetzte, zusätzliche Referenzsignale der Steuerung zuführt. Hierbei wird die Übertragung der Signale über ein Kabel möglich, das dem entspricht, wie es bei Anlagen mit inkrementalen Drehgebern als indirektes Meßsystem erforderlich ist. Weitere vorteilhafte Ausgestaltungen der Erfindung sind in den Unteransprüchen gekennzeichnet.

Die Erfindung wird anhand der in den Zeichnungen dargestellten Ausführungsformen näher erläutert.

Fig. 1     zeigt den mechanischen Aufbau und das Schaltungsprinzip einer erfindungsgemäßen Meßeinrichtung,

Fig. 2     ein Prinzipschaltbild für die Verarbeitung der Signale aus der Meßeinrichtung gemäß Fig. 1,

Fig. 3     ein Signal-Diagramm der Meßeinrichtung zur Errechnung des Lageistwertes und

Fig. 4     ein Signal-Diagramm gemäß Fig. 3 für einen Drehgeber mit 2500 Teilungsperioden.

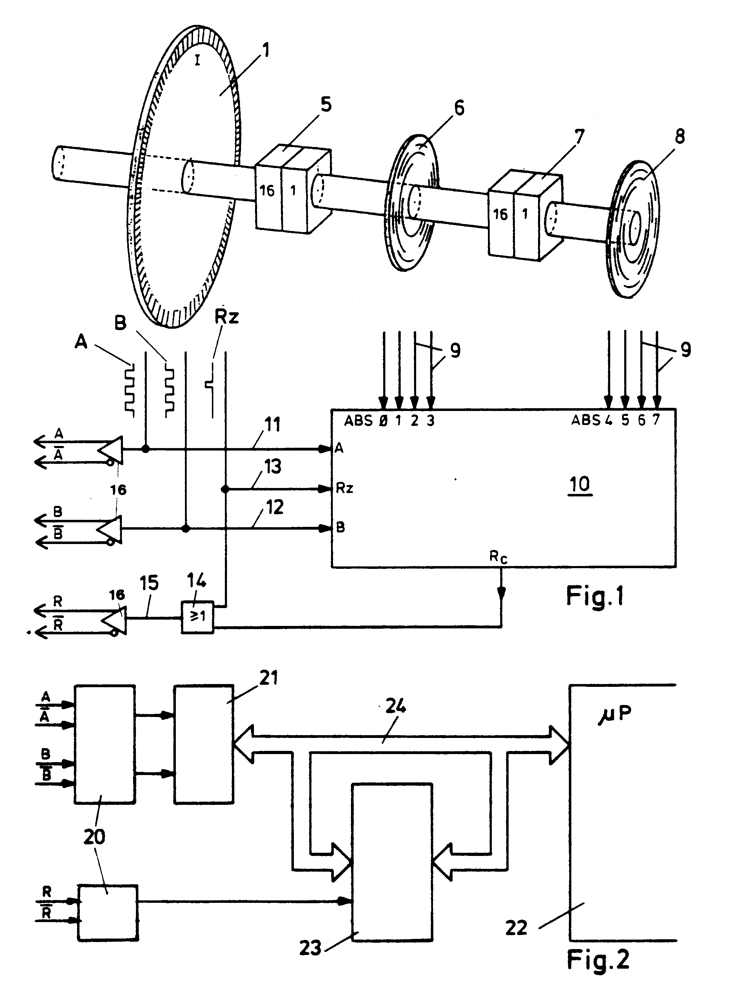

Das Meßsystem gemäß Fig. 1 besteht aus einem herkömmlichen, hochauflösenden inkrementalen Drehgeber 1 für zwei um 90 Grad versetzte Inkrementalsignale A, B und einem Referenzsignal Rz je Umdrehung. Der Drehgeber 1 ist über ein Untersetzungsgetriebe 5 mit einer Vier-bit-Absolutwertscheibe 6 und diese über ein zweites Untersetzungsgetriebe 7 mit einer zweiten Vier-bit-Absolutwertscheibe 8 verbunden. Entsprechend der Auflösung der beiden Absolutwertscheiben beträgt die Untersetzung der beiden Getriebe 5 und 7 16 : 1. Der Absolutwertgeber aus den Teilen 5 bis 8 kann so 256 Umdrehungen des Drehgebers 1 direkt erfassen. Die gleiche Umdrehungszahl läßt sich auch mit einem Untersetzungsgetriebe mit 256 : 1 und einer 8-bit Absolutwertscheibe erfassen, wenn z. B. aus Platzgründen dies vorteilhafter sein sollte. Wird eine höhere maximale Umdrehungszahl erforderlich, kann durch zusätzliche Absolutwertscheiben oder eine höhere Auflösung der Absolutwertscheiben mit entsprechenden Getriebeuntersetzungen diese höhere Umdrehungszahl erfaßt werden. Zum Beispiel mit zwei 5-bit Scheiben und Untersetzungsgetrieben mit 32 : 1 eine maximale Umdrehung von 1024.

Die Absolutwertsignale 9 sind einer einfachen Zähllogik 10 zugeführt, die über eine Leitung 11 die Inkrementalsignale A der ersten und über eine Leitung 12 der zweiten Spur des Drehgebers 1 erhält. Ausgehend von dem über eine weitere Leitung 13 zugeführten Referenzsignal Rz erzeugt die Zähllogik 10 ein zusätzliches Referenzsignal Rc, das über ein Oderglied 14 in den Signalweg 15 eingespeist wird. Zur besseren Überwachung und Störunterdrückung werden die zwei Inkrementalsignale A und B und das Referenzsignal Rz mit dem zusätzlichen Referenzsignal Rc über Verstärkerstufen 16 zusätzlich auch negiert übertragen, wie das bei Inkrementalgebern als indirektes Meßsystem üblich ist.

Die Zähllogik 10 kann störsicher aufgebaut direkt am Meßsystem angeordnet sein und die erforderliche Betriebsspannung von der Betriebsspannung für die Signalgeber (nicht dargestellt) erhalten. Würde das ganze Meßsystem als Absolutwertgeber aufgebaut werden, müßten für einen Inkrementalgeber mit 4000 Inkrementen und 256 Umdrehungen ein 20-bit Signal übertragen werden. Um dies in gleicher Weise sicher (auch negiert) parallel der Steuerung zuzuführen wäre hierzu ein 40adriges Kabel erforderlich und der Aufwand für die Fehlerüberwachung und Störunterdrückung entsprechend groß. Es ist bekannt, diesen Aufwand durch Verwendung einer seriellen Schnittstelle zu reduzieren, jedoch steht dann die Lageistwertinformation nicht ständig und aktuell zu jedem beliebigen Zeitpunkt zur Verfügung und es ergibt sich eine geringere Störsicherheit.

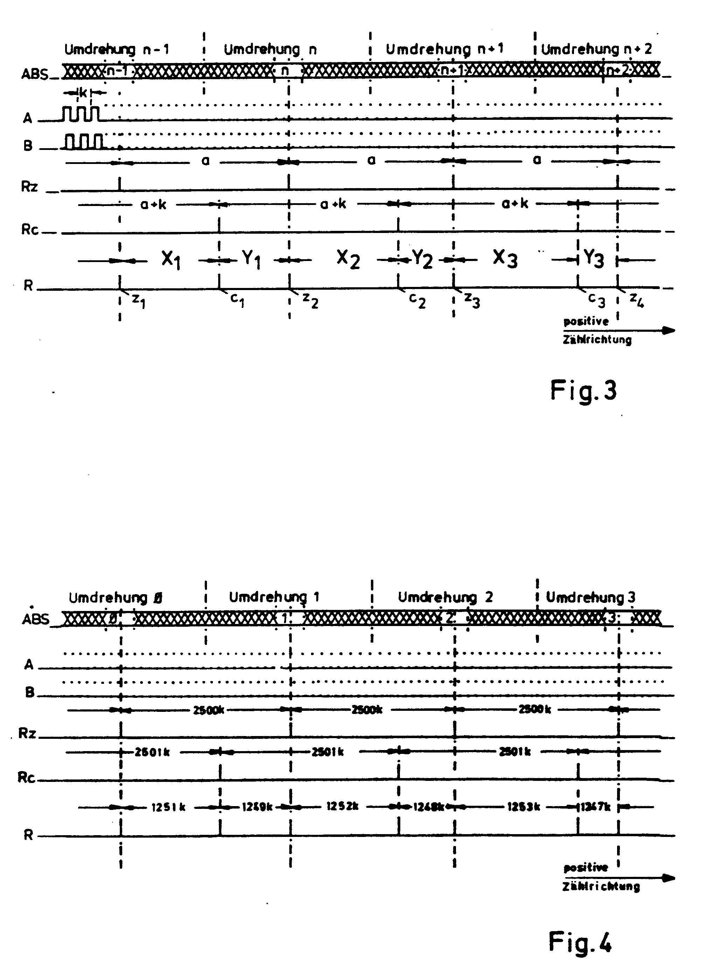

Die Wirkungsweise der Zähllogik 10 ist in Fig. 3 dargestellt. Die Zähllogik erhält das Absolutsignal ABS (9)der Absolutwertscheiben 6 und 8, die beiden Inkrementalsignale A und B und das Referenzsignal Rz. Bei Eintreffen eines Referenzsignales wird der Wert des Absolutsignales ABS mit $n - 1$, $n$, $n + 1$, $n + 2$ usw. abgespeichert. Die Werte dazwischen können im Toleranzbereich des Absolutwertgebers liegen ($n$ ist die Zahl der momentanen absoluten Umdrehung des Drehgebers 1). Ist $k$ eine Teilungsperiode der Inkrementalsignale A und B und $a$ die Anzahl der Teilungsperioden pro Umdrehung des Drehgebers 1, erzeugt die Zähllogik 10 in jeder Zählrichtung nach jeder Umdrehung alle $a + 1k$ eine zusätzliches Referenzsignal Rc. Die Zählrichtung wird in bekannter Weise aus der jeweiligen Phasenlage der Inkrementalsignale A zu B ermittelt.

Das erste zusätzliche Referenzsignal $c_1$ wird hierbei über den Zählerstand eines Auf/Abwärtszählers bei positiver Zählrichtung nach $X_1$ mit $a/2 + (n - 1) \cdot k + k$ hinter dem ersten Referenzsignal $z_1$ dann erzeugt, wenn die beiden Inkrementalsignale A und B einen "High"-Pegel führen. Nach $Y_1$ mit $a/2 - n \cdot k$ erfolgt dann die Ausgabe einer weiteren zyklischen Referenzmarke $z_2$ vom Inkrementalgeber. Nach $X_2$ mit $a/2 + n \cdot k + k$ erfolgt dann das zweite zusätzliche Referenzsignal $c_2$. $Y_2$ entspricht dann $a/2 - (n + 1) \cdot k$; $X_3 = a/2 + (n + 1) \cdot k + k$ und $Y_3 = a/2 - (n + 2) + k$. Hierbei entspricht $z$ dem zyklischen Referenzsignal und $c$ dem umdrehungscodierten Referenzsignal.

3

Um ausgehend von jedem zyklischen Referenzsignal Rz des inkrementalen Drehgebers in der Logikstufe 10 ein zusätzliches Referenzsignal Rc zu erzeugen das unabhängig von der Drehrichtung in einem Abstand der zyklischen Referenzmarke liegt aus dem sich der genaue Lageistwert ermitteln läßt, erzeugt die Logikstufe 10 bei positiver Drehrichtung ein zusätzliches Referenzsignal nach

$$X = a/2 + n \cdot k + k$$

und bei negativer Drehrichtung nach

$$Y = a/2 - n \cdot k.$$

Hierbei is n immer der absolute mit Rz abgetastete Drehzahlwert aus dem Absolutwertgeber (5 bis 8) bzw. den Signalen 9.

In Fig. 4 ist das gleiche Signal-Diagramm für einen inkrementalen Drehgeber mit 2500 Teilungsperioden k dargestellt. Wird hiermit z. B. die Spindel für ein Werkzeugmaschinen-Schlitten mit einer Steigung von 10 mm angetrieben, ergibt sich bei der üblichen Vierfachauswertung in der Empfänger-Elektronik bei einer Auflösung von 1 Mikrometer eine absolute Meßlänge von 2,560 Metern. Hierbei ist der Abstand zwischen einem zyklischen Referenzsignal Rz und einem codierten Referenzsignal Rc eindeutig, d. h. über die Vielzahl der Umdrehungen kommt jeder Abstand zahlenmäßig nur einmal vor. Somit ist über den unterschiedlichen Abstand zwischen den zyklischen und umdrehungscodierten Referenzsignalen eindeutig die jeweilige Umdrehung festgelegt. Die Position des Systems ist demnach für die Empfänger-Elektronik in der Steuerung eindeutig, absolut und inkrementgenau ermittelbar.

Mit dem erfindungsgemäßen Drehgeber ist auch eine Lageistwerterrechnung bei einem Endlos-Drehen möglich. Hierbei erfolgt die Ermittlung des Lageistwertes unabhängig von der Nullstellung der Absolutwertscheiben 6 und 8. Dies hat vor allem den Vorteil, daß bei der Montage des kompletten Drehgebers nicht auf dessen Drehstellung geachtet werden muß bzw. ein Justieren überflüssig wird. Hierbei ergibt sich dann ein Sonderfall bei den Übergängen zwischen der "nullten" Umdrehung und der "maximalen" Umdrehung.

Beispiel:

```
    a   = 2500 k
  ABS = 8 Bit = 256 Umdrehungen absolut


      Umdrehung        Umdrehung        Umdrehung
  <----- 255 -----><------ 0 ------><------ 1 ------>
        |                |                |
   995k | 1506k      Y   | 1251k    1249k | 1252k
     I        I          I        I       I
  -------- -------- -------- -------- -------- -------
     z        c          z        c       z
```

Die codierte Referenz-Marke c würde normalerweise bei negativer Drehrichtung von der zyklischen Referenzmarke 0 vorgegeben nach Gleichung $Y = a/2 - n \cdot k$.

Diese liefert für n = 0 den Wert a/2, was jedoch nach der Definition nicht zulässig ist, weil sonst die Eindeutigkeit nicht mehr vorhanden wäre. Andererseits muß unabhängig von der Drehrichtung auch beim Nullübergang die zusätzliche Referenzmarke immer im entsprechenden Abstand erfolgen. Um dies sicherzustellen, überwacht die Logikstufe den Umdrehungswert auf einen Wert n = Null und schaltet bei negativer Drehrichtung die Erzeugung der zusätzlichen Referenzmarke dahingehend um, daß diese - nur in diesem Fall - mit

$$Y = a/2 - n_{max} \cdot k - k$$

erzeugt wird.

$n_{max}$ entspricht hierbei dem höchsten Umdrehungswert bzw. der maximalen absoluten Umdrehung - 1.

Beispiel:

$$Y = \frac{2500k}{2} - 255k - k$$

$$= 994k$$

Die Empfänger-Elektronik kann gemäß Fig. 2 aufgebaut sein. Die Inkrementensignale A, $\overline{A}$ und $\overline{B}$, B werden, in einer Impulsaufbereitungsstufe 20 von Störsignalen befreit, einem Auf/Abwärtszähler 21 zugeführt, der diese Impulse in bekannter Weise drehrichtungsgemäß zählt. Der jeweilige Zählerstand wird über einen Signalbus 24 von einem Mikroprozessor 22 der Steuerung abgefragt. Gleichzeitig wird beim Eintreffen aller Referenzsignale R = Rz + Rc von einer Latch-Stufe 23 der jeweilige Zählerstand zwischengespeichert und gleichfalls dem Mikroprozessor 22 über den gleichen Signalbus 24 zur Verfügung gestellt.

Aus diesen Daten, z. B. durch Vergleich der anliegenden Werte mit zuvor anliegenden Werten, ermittelt der Mikroprozessor den Verfahrweg. Die absolute Position der ersten überfahrenen Referenzmarke in Bezug auf die zyklische Referenzmarke 0 errechnet sich hierbei (in Teilungsperioden k) aus:

$$Xabs_{(k)} = \left[\, |d| - sign(d) - 1\, \right] * \frac{a}{2} + \left[\, sign(d) - sign\left(\frac{dX}{}\right) \right] * \frac{|dX|}{2} \qquad \text{Gleichung 1}$$

Daraus ergibt sich die absolute Position in mm:

$$Xabs_{(mm)} = Xabs_{(k)} * k \qquad \text{Gleichung 2}$$

In Gleichung 1 und 2 bedeuten:

| | |
|---|---|
| $Xabs_{(k)}$ = | Abstand zwischen der ersten überfahrenen Referenzmarke und der Referenzmarke 0 in Teilungsperioden k |
| $Xabs_{(mm)}$ = | Abstand zwischen der ersten überfahrenen Referenzmarke und der Referenzmarke 0 in mm |
| d = | 2 \|dX\| - a |
| dX = | Vorzeichenrichtige Anzahl der Teilungsperioden zwischen der ersten und der zweiten in einer Richtung überfahrenen Referenzmarke |
| a = | Anzahl der Teilungsperioden k pro Umdrehung |
| k = | Teilungsperiode (repräsentiert über die Spindelsteigung ein Längenmaß) |
| sign = | Signum-Funktion |

Bei dem Beispiel gemäß Fig. 4 kann sich hierbei folgendes ergeben:

| | |
|---|---|
| a = | 2500 k |
| ABS = | 256 Umdrehungen |
| E = | Einschalt-Position innerhalb Umdrehung 6 (siehe nachfolgendes Bild) |

negative Drehrichtung während der Initialisierung

```
                                                    Init.      |E
                                              <---------- |
                                                          v

   Umdrehung          Umdrehung          Umdrehung          Umdrehung

 - 0 ------>< ------ 1 ----- // ----- 5 ------>< ------ 6 -----
   |           |           |           |           |           |
   | 1251k   1249k | 1252k   1245k | 1256k   1244k | 1257k
   I         I         I                 I         I         I
-- ------- -------- ------ // ------- -------- ---------- ------
   z               z                 z         c         z
   |                                                     |
   |<------------------------ // --- Xabs -------------->|
```

positive

--------------->

Drehrichtung

Bei der angenommenen Einschalt-Position E wird zunächst bei negativer Drehrichtung die zyklische Referenzmarke 6 überfahren. Nach weiteren 1244 Teilungsperioden wird von der Zähllogik 10 die umdrehungscodierte Referenzmarke c erzeugt. Nach Gleichung 1 ergibt sich die absolute Position der ersten überfahrenen Referenzmarke zu:

$$dX = -1244$$

$$d = 2 * |-1244| - 2500 = -12$$

$$Xabs_{(k)} = \left[ \; |-12| - sign(-12) - 1 \; \right] * \frac{2500}{2}$$

$$+ \left[ \; sign(-12) - sign(-1244) \; \right] * \frac{|-1244|}{2}$$

$$= \left[ \; 12 + 1 - 1 \; \right] * 1250 + \left[ \; -1 + 1 \; \right] * 622$$

$$= \underline{15000 \; k}$$

Nach Gleichung 2 ergibt sich die absolute Position in mm:

$$Xabs_{(mm)} = 15000 \bullet \frac{10 \text{ mm/Umdr.}}{2500 \text{ Striche/Umdr.}}$$

$$= 15000 \bullet 4 \text{ µm}$$

$$= \underline{60 \text{ mm}}$$

Das Initialisieren erfolgt hierbei selbstätig nach dem Einschalten der Steuerung, wobei die Steuerung sicherstellt, daß sich hierbei das Werkzeug außerhalb des Werkstückes bewegt oder sich von diesem wegbewegt. Wird hierzu eine Bewegung in positiver Drehrichtung erforderlich, erfolgt die Berechnung wie folgt:

```
                                                  |E      Init.
                                                  |       ---------->
                 .              .                 v
   Umdrehung         Umdrehung         Umdrehung         Umdrehung
 - 0 ------><------ 1 ----- // ----- 4 ------>< ------ 5 -----
   |                       |                 |                 |
   | 1251k      1249k | 1252k      1246k | 1255k      1245k | 1256k
   I         I         I                 I         I         I
 -- ------- -------- ------ // ------ ------- --------- ------
   z                 z                 z         c         z
   |                                                       |
   |<------------------------ // --- Xabs --------------->|
```

```
                                           positive
                                           -------------->
                                           Drehrichtung
```

Bei der angenommenen Einschalt-Position E wird zunächst bei positiver Drehrichtung die codierte Referenzmarke c überfahren. Nach weiteren 1245 Teilungsperioden wird vom Inkrementalgeber die zyklische Referenzmarke 5 erzeugt. Nach Gleichung 1 ergibt sich die absolute Position der ersten überfahrenen Referenzmarke zu:

$$dX = +1245$$

$$d = 2 \cdot |+1245| - 2500$$

$$= -10$$

$$Xabs_{(k)} = \left[\ |-10| - \text{sign}(-10) - 1\ \right] \cdot \frac{2500}{2}$$

$$+ \left[\ \text{sign}(-10) - \text{sign}(+1245)\ \right] \cdot \frac{|+1245|}{2}$$

$$= \left[\ 10 + 1 - 1\ \right] \cdot 1250 + \left[\ -1 - 1\ \right] \cdot \frac{1245}{2}$$

$$= 12500\ k - 1245\ k$$

$$= \underline{11255\ k}$$

Nach Gleichung 2 ergibt sich die absolute Position in mm:

$$Xabs_{(mm)} = 11255 \cdot \frac{10\ mm/Umdr.}{2500\ Striche/Umdr.}$$

$$= 11255 \cdot 4\ \mu m$$

$$= \underline{45,020\ mm}$$

Ist der Verfahrweg zur Initialisierung zu lang, kann dieser durch weitere Referenzmarken auf dem Drehgeber 1 z. B. bei 180 ° verkürzt werden.

Durch eine entsprechende Anpassung der Untersetzungsgetriebe für die Absolutwertscheiben oder durch Zusatzreferenzmarken auf einer getrennten Spur oder mit verändertem Signal können dann codierte Referenzsignale ausgegeben werden, die bei jeder Umdrehung mehrfach jeweils um ein Inkrement versetzt ausgegeben werden.

Ist die Logikstufe 10 durch eine entsprechende Nullumschaltung (bei Umdrehungszahl Null und negativer Drehrichtung) für ein Endlosdrehen ausgebildet, kann der Nullpunkt der Meßeinrichtung im beliebigen Abstand zum Maschinennullpunkt liegen. Es wird dann lediglich einmal der Maschinennullpunkt angefahren, dort z. B. über die numerische Steuerung der Abstand der beiden Nullpunkte zueinander ermittelt und bei der späteren Lageistwerterfassung berücksichtigt.

Während bei inkrementalen Drehgebern als indirektes Meßsystem jeweils nur nach einer vollen Umdrehung, z. B. über eine Zählkontrolle, eine Überwachung auf Vollständigkeit der Inkremente erfolgen kann, wird beim erfindungsgemäßen Meßverfahren eine Kontrolle auch bei den codierten Referenzsignalen möglich. Gleichzeitig können durch eine Plausibilitätskontrolle auch die codierten Referenzsignale und mit diesen die Absolutwertgebersignale überwacht werden, da sich diese je nach Drehrichtung jeweils nur um eine Teilungsperiode gegenüber dem zyklischen Referenzsignal verschieben. Ist nur eine Referenzmarke vorgesehen und gemäß Fig. 4 maximal 256 Umdrehungen möglich, ergibt sich ein codiertes Referenzsignal

8

das nur um 0 ... 256 Teilungsperioden von dem 180° Wert bei Teilungsperiode 1250 abweicht, so daß eine Zählkontrolle bei jeder halben Umdrehung (0 ... 256 Teilungsperioden) des Drehgebers 1 möglich ist. Werden zusätzlich zyklische Referenzmarken verwendet, kann diese Kontrolle noch weiter verbessert werden.

**Patentansprüche**

1. Meßeinrichtung zur Lageistwerterfassung mit einem hochauflösenden Drehgeber (1), der neben Inkrementalsignalen wenigstens ein Referenzsignal (Rz) je Umdrehung abgibt, einem, über ein Getriebe mit dem Drehgeber verbundenen Referenzgeber (5 bis 8), einer Einrichtung, die ein entsprechend der Umdrehung des Drehgebers versetztes Referenzsignal erzeugt, und einer Empfängerelektronik (21 bis 24), die einen Mikroprozessor (22) aufweist, mit dessen Hilfe der absolute Lageistwert bei mehr als einer Umdrehung errechnet wird, dadurch gekennzeichnet, daß

   - der Referenzgeber ein Absolutwertgeber (5 bis 8) zur Erfassung der Zahl (n) der Umdrehungen des Drehgebers (1) ist, der hierzu über wenigstens ein Untersetzungsgetriebe (5) mit dem Drehgeber (1) verbunden ist,
   - als die das versetzte Referenzsignal erzeugende Einrichtung eine mit dem Absolutwertgeber (5 bis 8) und dem Drehgeber (1) für die Signalzuführung verbundene Logikstufe (10) vorgesehen ist, die so ausgebildet ist, daß sie bei Auftreten eines Referenzsignales ($R_Z$) die Zahl der Umdrehungen des Drehgebers (1) aus den Signalen des Absolutwertgebers (5 bis 8) ausliest und speichert, und ein zusätzliches, gegenüber dem Referenzsignal ($R_Z$) um eine der Zahl (n) der Umdrehungen des Drehgebers (1) entsprechende Anzahl von Teilungsperioden (K) versetztes Referenzsignal ($R_C$) erzeugt,
   - die Logikstufe (10) und der Drehgeber für die Zuführung der Referenzsignale ($R_Z$, $R_C$) und des Inkrementalsignales des Drehgebers (1) mit der Empfängerelektronik (21 bis 24) verbunden sind, und die Empfängerelektronik (21 bis 24) so ausgebildet ist, daß sie aus diesen Signalen den absoluten Lageistwert errechnen kann.

2. Meßvorrichtung nach Anspruch 1, dadurch gekennzeichnet, daß die Empfängerelektronik (21 bis 24) eine Impulsaufbereitungsstufe (20) zur Entstörung der eingehenden Signale (A, $\overline{A}$, B, $\overline{B}$, R, $\overline{R}$), einen Auf-/Abwärtszähler (21) für die Zählung der Impulse der vom Drehwertgeber (1) abgegebenen Inkrementalsignale (A, B) und eine Latchstufe (23) zur Zwischenspeicherung der Zählerstände aufweist, welche über einen Datenbus (24) mit dem Auf-/Abwärtszähler (21) und dem Mikrocomputer (22) in Verbindung steht.

3. Meßeinrichtung nach Anspruch 1 oder 2, dadurch gekennzeichnet, daß der Absolutwertgeber ein Drehgeber mit Absolutwert-Scheibe (6) ist, deren Auflösung der maximalen Anzahl von Umdrehungen des Inkrementalen Drehgebers (7) weitere Absolutwertscheiben vorgesehen sind die zusammen die maximalen Umdrehungen erfassen.

4. Meßeinrichtung nach einem der Ansprüche 1 bis 3, dadurch gekennzeichnet, daß sie derart ausgebildet ist, daß das zusätzliche Referenzsignal (Rc) in den Signalweg (15) für das Referenzsignal (Rz) des inkrementalen Drehgebers (1) eingespeist und neben den Inkrementalsignalen (A, B) des Drehgebers über Signalauswertstufen (21) dem Mikroprozessor (22) zugeführt werden kann.

5. Meßeinrichtung nach einem der Ansprüche 1 bis 4, dadurch gekennzeichnet, daß der inkrementale Drehgeber (1) und der Absolutwertgeber (5 bis 8) zusammen mit der Logikstufe (10) baulich unmittelbar verbunden angeordnet sind, und über ein Verbindungskabel für die Zuführung der Inkrementalsignale (A, B) und der Referenzsignale (Rz, Rc) mit einer die Empfängerelektronik umfassenden Steuerung verbunden sind.

6. Meßeinrichtung nach einem der Ansprüche 1 bis 5, dadurch gekennzeichnet, daß der inkrementale Drehgeber (1) zumindest eine weitere Referenzmarke zur Aufteilung der vollen Umdrehung des Drehgebers (1) und zur Erzeugung eines weiteren Zusatzreferenzsignals in der Zähllogik (10) aufweist.

7. Meßverfahren mit einer Meßeinrichtung nach einem der Ansprüche 1 bis 6, dadurch gekennzeichnet, daß die Signale des Drehgebers (1) und des Absolutwertgebers (5 bis 8) über eine Logikstufe (10) abgetastet werden, bei Auftreten eines von dem Drehgeber (1) abgegebenen Referenzsignales ($R_Z$) aus den Signalen (9) des Absolutwertgebers (5 bis 8) die Zahl der Umdrehungen des Drehgebers (1) von der Logikstufe (10) ausgelesen und abgespeichert wird, nach Weiterbewegung des Drehgebers (1) um eine Anzahl von Inkrementen, die aus einer fest vorgegebenen Zahl sowie aus der aus dem Absolutwertgeber (5 bis 8) ausgelesenen Zahl der Umdrehungen gebildet ist, in der Logikstufe (10) ein zusätzliches Referenzsignal ($R_C$) erzeugt wird, und die Referenzsignale ($R_Z$, $R_C$) und die Inkrementalsignale des Drehgebers (1) der Empfängerelektronik (21 bis 24) zur Errechnung des Lageistwertes zugeführt werden.

8. Meßverfahren nach einem der Ansprüche 1 bis 7, dadurch gekennzeichnet, daß in an sich bekannter Weise die Inkrementalsignale (A,B) mit entsprechend der Drehrichtung phasenversetzten Inkrementalsignalen nach einer Impulsaufbereitung in einem Auf-/Abwärtszähler (21) drehrichtungsabhängig gezählt werden, der jeweilige Zählerstand durch die Referenzsignale (Rz) des Drehwertgebers (1) und den zusätzlichen Referenzsignalen (Rc) in eine Latchstufe (23) eingelesen wird, und daß der Zählerstand des Auf- Abwärtszählers (21) und der Latchstufe (23) über einen Datenbus vom Mikroprozessor (22) abgerufen wird, der über eine Subtraktion des abgerufenen Wertes vom zuvor abgerufenen Wert den Istverfahrweg ermittelt.

9. Meßverfahren nach Anspruch 7, dadurch gekennzeichnet, daß über die Zählerstände bei Eintreffen der beiden Referenzsignale (Rz, Rc) eine Vollständigkeitskontrolle der Inkrementalsignale (A,B) erfolgt, über eine Plausibilitatskontrolle der richtige Zählerstand für das zusätzliche Referenzsignal (Rc) überprüft wird und bei einem fehlerhaftem Signal ein Fehlersignal erzeugt wird.

10. Meßverfahren nach einem der Ansprüche 7 bis 9, dadurch gekennzeichnet, daß zumindest einmal nach dem ersten Einschalten eine gesteuerte Einfahrbewegung erfolgt, hierbei, ausgehend vom ersten Referenzsignal ($R_Z$) des Drehgebers (1), nach Weiterbewegung des Drehgebers (1) um eine Zahl von Inkrementen in der Logikstufe (10) ein zusätzliches Referenzsignal ($R_C$) erzeugt wird, wobei die Zahl von Inkrementen aus einer fest vorgegebenen Zahl sowie aus der aus dem Absolutwertgeber (5 bis 8) ausgelesenen Zahl der Umdrehungen des Drehgebers (1) gebildet wird.

11. Meßverfahren nach Anspruch 10, dadurch gekennzeichnet, daß der feste Zahlenwert der Hälfte der Gesamtzahl an Inkrementen zwischen zwei Referenzsignale (Rz) des Drehwertgebers (1) entspricht.

12. Meßverfahren nach einem der Ansprüche 7 bis 11, dadurch gekennzeichnet, daß der Lageistwert unabhängig vom Wert der Signale (9) des Absolutwertgebers (5 bis 8) aus dem Abstand der Referenzsignale (Rz) zu den zusätzlichen Referenzsignalen (Rz) ausgehend von einem vorgegebenen Maschinennullpunkt errechnet wird.

13. Meßverfahren nach einem der Ansprüche 7 bis 12, dadurch gekennzeichnet, daß ausgehend vom Referenzsignal (Rz) das zusätzliche Referenzsignal nach a/2 + n k + k, und in negativer Richtung nach a/2 - n k erzeugt wird, wobei: a der Anzahl der Teilungsperioden bei einer Umdrehung, n der Zahl der absoluten Umdrehung des Drehgebers (1), und k einer Teilungsperiode der Inkrementsignale (A,B) entspricht.

14. Meßverfahren nach Anspruch 13, dadurch gekennzeichnet, daß bei einem Umrechungswert n = Null und negativer Drehrichtung eine Umschaltung der Erzeugung des zusätzlichen Referenzsignales erfolgt und dieses nach a/2 -$n_{max}$ k -k erzeugt wird, wobei: $n_{max}$ der höchsten Zahl der absoluten Umdrehung des Drehgebers entspricht.

## Claims

1. Measuring device for detecting the actual position value, comprising a high-resolution rotary transducer (1) which, in addition to incremental signals, outputs at least one reference signal (Rz) per revolution, a reference transmitter (5 to 8) connected via a gear to the rotary transducer, a device which generates a reference signal offset in accordance with the revolution of the rotary transducer, and receiver electronics (21 to 24), which exhibit a microprocessor (22), with the aid of which the absolute actual position value at more than one revolution is calculated, characterised in that
   - the reference transmitter is an absolute-value transmitter (5 to 8) for detecting the number (n) of revolutions of the rotary transducer (1) which is connected via at least one reduction gear (5) to

10

the rotary transducer (1) for this purpose,

- a logic stage (10) connected to the absolute-value transmitter (5 to 8) and the rotary transducer (1) for the signal supply is provided as the device generating the offset reference signal, which is constructed in such a manner that, when a reference signal ($R_z$) occurs, it reads out, and stores, the number of revolutions of the rotary transducer (1) from the signals of the absolutevalue transmitter (5 to 8), and generates an additional reference signal ($R_c$) which is offset with respect to the reference signal ($R_z$) by a number of division periods (K) corresponding to the number (n) of revolutions of the rotary transducer (1),

- the logic stage (10) and the rotary transducer for supplying the reference signals ($R_z$, $R_c$) and the incremental signal of the rotary transducer (1) are connected to the receiver electronics (21 to 24) and the receiver electronics (21 to 24) are constructed in such a manner that they can calculate the absolute actual position value from these signals.

2. Measuring device according to Claim 1, characterised in that the receiver electronics (21 to 24) exhibit a pulse processing stage (20) for removing interference from the incoming signals (A, $\overline{A}$, B, $\overline{B}$, R, $\overline{R}$), an up/down counter (21) for counting the pulses of the incremental signals (A, B) output by the rotary value transducer (1) and a latch stage (23) for temporarily storing the counts, which is connected to the up/down counter (21) and the microcomputer (22) via a data bus (24).

3. Measuring device according to Claim 1 or 2, characterised in that the absolute-value transmitter is a rotary transducer with absolute-value disc (6), the resolution of which [sic] the maximum number of revolutions of the incremental rotary transducer (7) further absolute-value discs are provided which together detect the maximum revolutions [sic].

4. Measuring device according to one of Claims 1 to 3, characterised in that it is constructed in such a manner that the additional reference signal (Rc) can be fed into the signal path (15) for the reference signal (Rz) of the incremental rotary transducer (1) and, in addition to the incremental signals (A, B) of the rotary transducer, can be supplied to the microprocessor (22) via signal processing stages (21).

5. Measuring device according to one of Claims 1 to 4, characterised in that the incremental rotary transducer (1) and the absolute-value transmitter (5 to 8), together with the logic stage (10), are constructionally arranged to be directly connected and are connected via a connecting cable for supplying the incremental signals (A, B) and the reference signals (Rz, Rc) to a control system comprising the receiver electronics.

6. Measuring device according to one of Claims 1 to 5, characterised in that the incremental rotary transducer (1) exhibits at least one further reference mark for dividing the full revolution of the rotary transducer (1) and for generating a further additional reference signal in the counting logic (10).

7. Measuring method with a measuring device according to one of Claims 1 to 6, characterised in that the signals of the rotary transducer (1) and of the absolute-value transmitter (5 to 8) are sampled via a logic stage (10), when a reference signal ($R_z$) output by the rotary transducer (1) occurs, the number of revolutions of the rotary transducer (1) is read out, and stored, by the logic stage (10) from the signals (9) of the absolute-value transmitter (5 to 8), an additional reference signal ($R_c$) is generated in the logic stage (10) after the rotary transducer (1) has moved on by a number of increments which is formed from a predetermined number of revolutions and from the number of revolutions read out of the absolute-value transmitter (5 to 8), and the reference signals ($R_z$, $R_c$) and the incremental signals of the rotary transducer (1) are supplied to the receiver electronics (21 to 24) for calculating the actual position value.

8. Measuring method according to one of Claims 1 to 7, characterised in that, in a manner known per se, the incremental signals (A, B) are counted direction-of-rotation-dependently in an up/down counter (21) with incremental signals which are offset in phase in accordance with the direction of rotation, after pulse processing, the respective count is read into a latch stage (23) by the reference signals (Rz) of the rotary value transducer (1) and the additional reference signals (Rc), and in that the count of the up/down counter (21) and of the latch stage (23) is called up via a data bus by the microprocessor (22) which determines the actual travel by subtracting the value called up from the value previously called up.

11

**9.** Measuring method according to Claim 7, characterised in that the incremental signals (A, B) are checked for completeness via the counts on arrival of the two reference signals (Rz, Rc), the correct count for the additional reference signal (Rc) is checked via a plausibility check and an error signal is generated in the case of a faulty signal.

**10.** Measuring method according to one of Claims 7 to 9, characterised in that a controlled moving-in movement occurs at least once after the first switching-on, during this process, starting from the first reference signal ($R_z$) of the rotary transducer (1), an additional reference signal ($R_c$) is generated in the logic stage (10) after the rotary transducer (1) has moved on by a number of increments, the number of increments being formed from a predetermined number of revolutions and from the number of revolutions of the rotary transducer (1) read out of the absolute-value transmitter (5 to 8).

**11.** Measuring method according to Claim 10, characterised in that the fixed numerical value corresponds to one half of the total number of increments between two reference signals (Rz) of the rotary value transducer (1).

**12.** Measuring method according to one of Claims 7 to 11, characterised in that the actual position value is calculated, starting from a predetermined zero point of the machine, from the distance of the reference signals (Rz) from the additional reference signals (Rz) [sic], independently of the value of the signals (9) of the absolute-value transmitter (5 to 8).

**13.** Measuring method according to one of Claims 7 to 12, characterised in that, starting from the reference signal (Rz), the additional reference signal is generated in accordance with a/2 + n k + k, and in accordance with a/2 - n k in a negative direction, in which: a corresponds to the number of division periods with one revolution, n corresponds to the number of the absolute revolution of the rotary transducer (1), and k corresponds to one division period of the increment signals (A, B).

**14.** Measuring method according to Claim 13, characterised in that with a conversion value n = zero and negative direction of rotation, the generation of the additional reference signal is switched over and this signal is generated in accordance with a/2 - $n_{max}$ k - k, in which: $n_{max}$ corresponds to the maximum number of the absolute revolution of the rotary transducer.

**Revendications**

**1.** Dispositif de mesure pour détecter la position réelle avec un détecteur (1) à haute résolution, qui délivre outre des signaux à incrémentation au moins un signal de référence (Rz) à chaque tour, à un transmetteur de référence (5 à 8), relié au détecteur par une transmission, d'un dispositif, qui produit un signal de référence décalé correspondant à la rotation du détecteur, et d'une électronique réceptrice (21 à 24) qui présente un microprocesseur (22) à l'aide duquel la position réelle est calculée quand il y a plus qu'un tour, dispositif de mesure caractérisé en ce que :
    - le transmetteur de référence est un transmetteur de valeur absolue (5 à 8) pour la détection du nombre (n) des tours du détecteur (1), transmetteur qui est relié pour cela au détecteur (1) par au moins une transmission démultiplicatrice (5),
    - il est prévu, comme dispositif produisant le signal de référence décalé, un étage logique relié au transmetteur de valeur absolue (5 à 8) et au détecteur (1) pour l'acheminement des signaux, qui est constitué de telle façon que lors de l'arrivée d'un signal de référence (Rz), il sélectionne et met en mémoire le nombre de tours du détecteur (1) à partir des signaux du transmetteur de valeur absolue (5 à 8) et produit un signal de référence (Rc) additionnel décalé par rapport au signal de référence (Rz) d'un nombre de graduations (K) correspondant au nombre (n) des tours du détecteur (1),
    - l'étage logique (10) et le détecteur sont reliés pour l'acheminement des signaux de référence ($R_z$, $R_c$) et du signal d'incrémentation du détecteur (1) à l'électronique réceptrice (21 à 24) et l'électronique réceptrice (21 à 24) est constituée de telle façon qu'elle peut calculer la position réelle absolue à partir de ces signaux.

**2.** Dispositif de mesure selon la revendication 1, caractérisé en ce que l'électronique réceptrice (21 à 24) présente un étage (20) de préparation des impulsions pour déparasiter les signaux entrants (A, $\overline{A}$, B, $\overline{B}$, R, $\overline{R}$), un compteur incrémenteur/décrémenteur (21) pour le comptage des impulsions des signaux d'incrémentation (A, B) délivrées par le détecteur (1) et un étage (23) pour la mise en mémoire intermédiaire des positions de compteur, étage (20) qui est relié par un collecteur de données (24) au compteur incrémenteur/décrémenteur (21) et au microcalculateur (22).

3. Dispositif de mesure selon la revendication 1 ou 2, caractérisé en ce que le transmetteur de valeur absolue est un détecteur avec un disque des valeurs absolues (6), dont la résolution correspond au nombre maximal de tours du détecteur à incrémentation (7) d'autres disques de valeurs absolues étant prévus, qui détectent ensemble les tours maximals.

4. Dispositif de mesure selon l'une des revendications 1 à 3, caractérisé en ce qu'il est constitué de telle façon que le signal additionnel de référence (Rc) peut être envoyé dans le circuit (15) pour le signal de référence (Rz) du détecteur (1) à incrémentation et peut être actionné en plus des signaux (A, B) d'incrémentation du détecteur par des étages d'exploitation de signaux (21) vers le microprocesseur (22).

5. Dispositif de mesure selon l'une des revendications 1 à 4, caractérisé en ce que le détecteur (1) incrémental et le transmetteur de valeur absolue (5 à 8) en même temps que l'étage logique (10) sont par construction reliés directement, et sont reliés à une commande comprenant l'électronique réceptrice par un câble de liaison pour l'acheminement des signaux d'incrémentation (A, B) et des signaux de référence (Rz, Rc).

6. Dispositif de mesure selon l'une des revendications 1 à 5, caractérisé en ce que le détecteur incrémental (1) présente un autre trait repère pour la division du tour complet du détecteur (1) et pour la production d'un autre signal de référence additionnel dans la logique de comptage (10).

7. Procédé de mesure avec un dispositif de mesure selon l'une des revendications 1 à 6, caractérisé en ce que les signaux du détecteur (1) et du transmetteur de valeur absolue (5 à 8) sont détectés par un étage logique (10), lors de l'arrivée d'un signal de référence (Rz) délivré par le détecteur (1) à partir des signaux (9) du transmetteur de valeur absolue (5 à 8) le nombre de tours du détecteur (1) est sélectionné et mis en mémoire par l'étage logique (10), après un nouveau mouvement du détecteur (1) d'un nombre d'incréments, qui est formé à partir d'un nombre fixe prédéfini ainsi qu'à partir du nombre de tours sélectionné à partir du transmetteur de valeur absolue (5 à 8), un signal de référence ($R_c$) additionnel est produit dans l'étage logique (10) et les signaux de référence ($R_z$, $R_c$) et les signaux d'incrémentation du détecteur (1) sont acheminés dans l'électronique réceptrice (21 à 24) pour le calcul de la position réelle.

8. Procédé de mesure selon l'une des revendications 1 à 7, caractérisé en ce que d'une manière connue en soi les signaux d'incrémentation (A, B) sont comptés avec des signaux d'incrémentation à phase décalée correspondant au sens de rotation après une préparation des impulsions dans un compteur incrémenteur/décrémenteur (21), en fonction du sens de rotation l'état respectif du compteur est mis en mémoire par les signaux de référence (Rz) du détecteur (1) et les signaux de référence (Rc) additionnels dans un étage (23) et en ce que l'état du compteur incrémenteur/décrémenteur (21) et l'étage (23) sont extraits du microprocesseur (22) par un collecteur de données, microprocesseur qui détecte par une soustraction de la valeur extraite auparavant, la position réelle.

9. Procédé selon la revendication 7, caractérisé en ce que l'on réalise un contrôle complet des signaux d'incrémentation par les états de compteur lors de l'arrivée des deux signaux de référence (Rz, Rc), on vérifie l'état exact du compteur pour le signal de référence additionnel (Rc) par un contrôle de plausibilité et on obtient un signal d'erreur dans le cas d'un signal défectueux.

10. Procédé de mesure selon l'une des revendications 7 à 9, caractérisé en ce qu'au moins une fois après la première mise en marche, on produit un mouvement d'entrée commandé, dans ce cas, provenant du premier signal de référence ($R_z$) du détecteur (1), après un autre mouvement du détecteur (1) d'un certain nombre d'incréments dans l'étage logique (10), on produit un signal de référence additionnel ($R_c$), le nombre d'incréments étant formé à partir du nombre, prédéfini de façon fixe ainsi que du nombre sélectionné à partir du transmetteur de valeur absolue (5 à 8), de tours du détecteur (1).

11. Procédé de mesure selon la revendication 10, caractérisé en ce que la valeur fixe du nombre correspond à la moitié du nombre total des incréments entre les deux signaux de référence (Rz) du détecteur (1).

12. Procédé de mesure selon l'une des revendications 7 à 11, caractérisé en ce que la position réelle indépendamment de la valeur des signaux (9) du transmetteur de valeur absolue (5 à 8) est calculée à partir de la distance des signaux de référence (Rz) aux signaux de référence additionnels (Rz) à partir d'un point zéro prédéfini de la machine.

13. Procédé selon l'une des revendications 7 à 12, caractérisé en ce qu'à partir du signal de référence (Rz) le signal de référence additionnel est produit selon a/2 + nK + K et dans le sens négatif selon a/2 - nk, formule dans lesquelles : a est le nombre des graduations lors d'un tour, n le nombre de tour absolu du détecteur (1) et k correspond à une graduation des signaux d'incrémentation (A, B).

14. Procédé selon la revendication 13, caractérisé en ce que dans le cas d'une valeur du nombre de tours n = zéro et d'un sens de rotation négatif, il se produit une inversion de la production du signal de référence additionnel et celui-ci est produit selon a/2 - $n_{max}$ • k - k, formule dans laquelle $n_{max}$ correspond au nombre le plus élevé du tour absolu du détecteur.

Fig.1

Fig.2

Fig. 3

Fig. 4